# EUROPÄISCHE PATENTSCHRIFT

(11) **EP 2 469 213 B1**
(45) Veröffentlichungstag und Bekanntmachung des Hinweises auf die Patenterteilung: **20.06.2018**
(21) Anmeldenummer: 11009976.9
(22) Anmeldetag: 19.12.2011
(51) Int. Cl.: F25B 21/02, F28F 1/42, F28F 3/02, H01L 35/30

(54) **Thermoelektrisches Wärmetauschen**
Thermo-electric heat exchange
Echangeur de chaleur thermoélectrique

(30) Priorität: 24.12.2010 DE 102010056170
(43) Veröffentlichungstag der Anmeldung: 27.06.2012
(73) Patentinhaber: Volkswagen Aktiengesellschaft, 38440 Wolfsburg (DE)
(72) Erfinder: Köhler, Jürgen, Prof. Dr., 38173 Sickte (DE); Böttcher, Christof, Dr., 38442 Wolfsburg (DE); Beermann, Jürgen, 31535 Neustadt (DE); Dilger, Klaus, Prof. Dr., 38106 Braunschweig (DE); Junior, Christine Susanne, Dr., 38100 Braunschweig (DE)

(56) Entgegenhaltungen:
- EP-A1- 1 662 223
- EP-A2- 2 230 701
- WO-A1-01/11920
- DE-A1- 19 946 131
- DE-A1-102008 060 153
- DE-U- 1 944 351
- FR-A1- 2 223 652
- US-A- 5 385 020
- US-A- 5 544 487
- US-A1- 2004 076 214
- US-A1- 2005 072 165
- US-A1- 2007 220 902

## Beschreibung

Die Erfindung betrifft einen thermoelektrischen Wärmeübertrager sowie ein Verfahren zur Herstellung eines thermoelektrischen Wärmeübertragers jeweils nach den Oberbegriffen der unabhängigen Patentansprüche.

Im Zuge der Verbreitung von elektrisch angetriebenen Fahrzeugen werden entsprechend angepasste Heiz- und Klimatisierungssysteme benötigt, die anders als bei konventionellen Fahrzeugen ohne die Abwärme eines Verbrennungsmotors und ohne mechanische Antriebsleistungserbringung auskommen. Aufgrund des begrenzten Energieinhalts der zur Versorgung derartiger Heiz- und Klimatisierungssysteme erforderlichen elektrischen Energiespeicher ist eine hohe Effizienz dieser Systeme bei allen Betriebsbedingungen gefordert, um die Reichweite der Fahrzeuge nicht empfindlich einzuschränken. Zum Heizen und Kühlen des Innenraums derartiger Fahrzeuge bieten sich thermoelektrische Wärmeübertrager an.

Bekanntes Bestandteil dieser thermoelektrischen Wärmeübertrager sind thermoelektrische Vorrichtungen, mit denen Wärme von einem niedrigen auf ein hohes Temperaturniveau gepumpt werden kann. Bei der thermoelektrischen Vorrichtung kann es sich um ein Peltier-Element handeln, das unter Zuführung von elektrischer Energie eine auf der Kaltseite aufgenommene Wärmemenge auf die Warmseite des Peltier-Elements transportiert und dort wieder abgibt. Es ist bekannt, dass solche Peltier-Elemente üblicherweise zwischen zwei Fluidströme geschaltet werden, um einem der Fluidströme einen Wärmestrom zu entziehen und diesen zuzüglich einer elektrischen Leistung an einen weiteren Fluidstrom abzugeben. Bei den Fluidströmen kann es sich um Ströme eines flüssigen und/oder gasförmigen Mediums handeln.

Aus der US 2004/ 076214 A1 (entsprechend der WO 2005 020340 A2) sind Konzepte zur Erhöhung der Leistungsdichte von thermoelektrischen Systemen bekannt. Ein im Zusammenhang mit Figur 12 der genannten Druckschrift dargestelltes System entsprechend dem Oberbegriff von Anspruch 1 weist eine Vielzahl von thermoelektrischen Pellets und eine Vielzahl von ersten und zweiten Wärmetransportvorrichtungen auf, wobei zumindest einige der ersten Wärmetransportvorrichtungen sandwichartig zusammengefügt sind zwischen zumindest zwei thermoelektrischen Pellets und wobei zumindest einige der zweiten Wärmetransportvorrichtungen sandwichartig zwischen zumindest zwei thermoelektrischen Pellets angeordnet sind, so dass dadurch zumindest ein Stack von thermoelektrischen Elementen mit alternierenden ersten und zweiten Wärmetransportvorrichtungen gebildet wird. Dabei ist vorgesehen, dass zumindest einige der ersten Wärmetransportvorrichtungen und zumindest einige der zweiten Wärmetransportvorrichtungen von dem zumindest einen Stack in unterschiedlichen Richtungen abstehen. Weitere Aspekte eines derartigen thermoelektrischen Stacks sind in der WO 2008/013946 A2 beschrieben.

Ferner sind aus den Dokumenten US 2007/220902 A1, US 5,385,020 A, US 5,544,487 A, FR 2 223 652 A1 und US 2005/072165 A1 thermoelektrische Wärmeübertrager bekannt, wobei ein thermoelektrischer Stack eine Vielzahl von ersten Wärmetransportelementen und eine Vielzahl von zweiten Wärmetransportelementen aufweist und zumindest zwischen einem der ersten Wärmetransportelemente und einem der zweiten Wärmetransportelemente sandwichartig zumindest ein thermoelektrisches Pellet angeordnet ist und die ersten und zweiten Wärmetransportelemente alternierend und angeordnet sind. Der thermoelektrische Stack ist dabei derartig bestrombar, dass sich an den ersten Wärmetransportelementen eine Warmseite und den zweiten Wärmetransportelementen eine Kaltseite des thermoelektrischen Stacks ausbildet. Dabei ist ein erster Fluidpfad als Rohr ausgebildet und zumindest eines der ersten Wärmetransportelemente ragt mit einem Vorsprung durch eine Durchbruchsöffnung in der Wandung des ersten Rohrs in einen das erste Fluid aufnehmenden ersten Innenraum.

Aufgabe der Erfindung ist es, ein verbessertes Übertragen von Wärmeströmen von den thermoelektrischen Pellets auf einen ersten Fluidstrom und einen zweiten Fluidstrom zu ermöglichen, insbesondere bei einem Kraftfahrzeug ein flexibles Thermomanagement unterschiedlicher Bauteile zu ermöglichen.

Die Aufgabe wird mit den Merkmalen der unabhängigen Patentansprüche gelöst. Weitere Ausführungsformen sind in den abhängigen Patentansprüchen zu finden.

Ein erfindungsgemäßer Wärmeübertrager zum Übertragen von Wärmeströmen von den thermoelektrischen Pellets auf einen ersten und einen zweiten Fluidstrom mit zumindest einem ersten Fluidpfad zum Führen des ersten Fluidstroms und zumindest einem zweiten Fluidpfad zum Führen des zweiten Fluidstroms und zumindest einem sandwichartig zwischen dem ersten Fluidpfad und dem zweiten Fluidpfad angeordneten oder anordenbaren thermoelektrischen Stack sieht vor, das der thermoelektrische Stack eine Vielzahl von ersten Wärmetransportelementen und eine Vielzahl von zweiten Wärmetransportelementen aufweist. Ferner ist zumindest eines der ersten Wärmetransportelemente und zumindest eines der zweiten Wärmetransportelemente sandwichartig zwischen zumindest zwei thermoelektrischen Pellets angeordnet. Dabei sind die ersten und zweiten Wärmetransportelemente alternierend zueinander angeordnet. In bekannter Weise ist der thermoelektrische Stack derart bestrombar, dass sich an den ersten Wärmetransportelementen eine Warmseite und den zweiten Wärmetransportelementen eine Kaltseite des thermoelektrischen Stacks ausbildet.

Bei dem Wärmeübertrager ist vorgesehen, dass der erste Fluidpfad als erstes Rohr ausgebildet ist, wobei zumindest eines der ersten Wärmetransportelemente mit einem von dem thermoelektrischen Stack abgewandten Vorsprung durch eine Durchbruchsöffnung in der Wandung des ersten Rohrs in einen das erste Fluid aufnehmenden ersten Innenraum ragt und / oder dass der zweite Fluidpfad als zweites Rohr ausgebildet ist, wobei zumindest eines der zweiten Wärmetransportelemente mit einem von dem thermoelektrischen Stack abgewandten Vorsprung durch eine Durchbruchsöffnung in der Wandung des zweiten Rohrs in einen das zweite Fluid aufnehmenden zweiten Innenraum ragt. Als Rohr wird hier jedes Rohr mit einer an die Oberfläche des thermoelektrischen Stacks angepasster Wandungsform verstanden, insbesondere ein Flachrohr, vorzugsweise mit einer kleineren inneren Höhe als Breite. Denkbar wären aber auch Rohre mit ellipsoiden Querschnitt oder abgeflachte Kreisprofilen.

Die Erfindung zeichnet sich dadurch aus, dass zumindest einer der durch die Wandung des ersten und/oder zweiten Rohrs in den Innenraum ragenden Vorsprünge mit einer elektrisch nichtleitenden, jedoch thermisch leitenden Beschichtung, wozu beispielsweise Keramiken, Lacke oder Polymere Verwendung finden, versehen ist, womit eine Material einsparende, Kurzschluss vermeidende, gleichzeitig jedoch eine thermisch effiziente und eine schnelle Wärmeübertragung ermöglichende Struktur des Wärmeübertragers geschaffen werden kann.

Die Wärmetransportelemente sind vorzugsweise als quaderförmige Brücken aus einem Metall mit guter elektrischer und thermischer Leitfähigkeit wie beispielsweise Kupfer ausgebildet und weisen Vorsprünge auf, die derart dimensioniert sind, dass diese in den Innenbereich der Rohre hineinragen können.

Die Ausbildung der Wärmetransportelemente und der Fluidpfade als Rohre, in deren Innenraum ein oder mehrere Vorsprünge der Wärmetransportelemente des thermoelektrischen Stacks hineinragen, ermöglicht eine vereinfachte Fertigung und die Einsparung der ansonsten notwendigen zusätzlichen Materialschichten zwischen dem thermoelektrischen Stack und den mit dem thermoelektrischen Stack gekoppelten Fluidpfaden. Da die Wärmetransportelemente unmittelbar in das in dem Rohr geführte wärmeübertragende Medium reichen können, werden ferner thermische Verluste durch Wärmeübergänge vermieden oder zumindest verringert.

Eine weitere Ausführungsform der Erfindung zeichnet sich dadurch aus, dass eine von einer Vielzahl von nebeneinander angeordneten oder anordenbaren thermoelektrischen Stacks mit in gleicher Richtung orientierten Warm- und Kaltseiten gebildete thermoelektrische Schicht vorgesehen ist, so dass eine hohe Wärmeübertragungsrate erreicht werden kann. Vorzugsweise sind die Stacks einer thermoelektrischen Schicht elektrisch in Reihe geschaltet.

Eine weitere Ausführungsform der Erfindung mit einer noch höheren Wärmeübertragungsrate zeichnet sich dadurch aus, dass eine Vielzahl von thermoelektrischen Schichten mit zumindest einem sandwichartig zwischen jeweils zwei der thermoelektrischen Schichten angeordneten oder anordenbaren Rohr vorgesehen sind und dabei einen Stapel bilden können. Die thermoelektrischen Schichten weisen jeweils eine Warmseite und eine Kaltseite auf und sind derartig relativ zu einem dazwischen liegenden Rohr orientiert, dass jeweils zwei thermoelektrische Schichten dem Rohr jeweils entweder mit ihren Warmseiten oder mit ihren Kaltseiten benachbart sind.

Bei dem erfindungsgemäßen thermoelektrischen Wärmeübertrager weisen die Wärmetransportelemente Vorsprünge auf, von denen zumindest einer eine Länge LV > 2,5 B_{B} aufweist, so dass ohne weitere Wärmeleitungselemente ein Wärmestrom zu relativ weit von den thermoelektrischen Pellets entfernt angeordneten räumlichen Stellen geleitet und an ein Wärmeübertragungsmedium angekoppelt werden kann. Hier bezeichnet B_{B} in der aus der WO 2008/013946 A2 bekannten Terminologie die aktive Breite des jeweiligen Wärmetransportelements. Typischerweise hat eine Vielzahl von Vorsprüngen eine Länge LV > 2,5 B_{B} und kann damit den thermoelektrischen Stack mit einem Wärmeträgermedium koppeln. Ferner umfasst die Erfindung auch Ausbildungsformen mit LV > 3,0 B_{B}, LV > 4,0 B_{B}.

Der thermoelektrische Stack ist fluiddicht im Bereich der Durchbrüche gegenüber dem Innenraum der Rohre abgedichtet, beispielsweise mittels Dichtelementen. Zur Vermeidung von Kurzschlüssen sind ferner Isolationsmittel vorgesehen, mit denen die Vorsprünge elektrisch gegeneinander und gegenüber einem im Fluidpfad geführten Medium isoliert oder isolierbar sind.

Eine weitere Ausführungsform der Erfindung zeichnet sich dadurch aus, dass das erste und / oder zweite Rohr aus einem elektrisch nicht leitenden Material hergestellt ist, womit auch bei der Verwendung von elektrisch leitfähigen Wärmeträgermedien im Fluidpfad Kurzschlüsse vermieden werden können. Es versteht sich, dass die Rohre grundsätzlich auch aus einem leitfähigen Material bestehen können.

Eine weitere Ausführungsform der Erfindung zeichnet sich dadurch aus, dass das erste und / oder zweite Rohr aus einem vorzugsweise thermisch schmelzbaren Kunststoffmaterial, beispielsweise aus einem polymeren oder elastomeren Material, hergestellt ist, womit eine hohe Fertigungsfreundlichkeit erreicht wird.

Eine weitere Ausführungsform der Erfindung zeichnet sich dadurch aus, dass zumindest eine der Durchbruchöffnungen durch eine Erhitzung von zumindest einem der Wärmetransportelemente und Schmelzen eines Materials des ersten oder zweiten Rohrs mittels des erhitzten Wärmetransportelements herstellbar ist, womit der Herstellungsprozess vereinfacht wird, da die Herstellung der Durchbruchöffnungen und das Einführen der Vorsprünge der Wärmetransportvorrichtungen in einem Arbeitsgang erfolgen kann. Das Bereitstellen des ersten Rohrs, des zweiten Rohrs und / oder des thermoelektrischen Stacks in einem Nahbereich des ersten und / oder zweiten Rohrs mit einem anschließenden Verringern des Abstandes zwischen dem ersten Rohr und dem thermoelektrischen Stack bzw. dem Verringern des Abstandes zwischen dem zweiten Rohr und dem thermoelektrischen Stack vereinfacht den Herstellungsprozess, da lediglich die drei Komponenten erstes Rohr, thermoelektrischer Stack und zweites Rohr zu montieren sind.

Bei dem erfindungsgemäßen Verfahren zur Herstellung einer thermoelektrischen Wärmepumpe ist vorgesehen
- Bereitstellen und Positionieren eines ersten Rohrs, welches als erster Fluidpfad vorgesehen ist
- Bereitstellen und Positionieren eines zweiten Rohrs, welches als zweiter Fluidpfad vorgesehen ist
- Bereitstellen und Positionieren eines thermoelektrischen Stacks zur Herstellung einer Verbindung des thermoelektrischen Stacks mit dem ersten und / oder zweiten Rohr.

Der Wärmeübertrager ist ausgebildet zum Übertragen eines Wärmestroms von den thermoelektrischen Pellets auf einen ersten und zweiten Fluidstrom mit zumindest einem ersten Fluidpfad zum Führen des ersten Fluidstroms und zumindest einem zweiten Fluidpfad zum Führen des zweiten Fluidstroms und umfasst den zumindest zwischen dem ersten Fluidpfad und dem zweiten Fluidpfad angeordneten oder anordenbaren thermoelektrischen Stack. Der thermoelektrische Stack weist eine Vielzahl von ersten Wärmetransportelementen und eine Vielzahl von zweiten Wärmetransportelementen auf. Zumindest eines der ersten Wärmetransportelemente und zumindest eines der zweiten Wärmetransportelemente ist sandwichartig zwischen zumindest zwei thermoelektrischen Pellets angeordnet, wobei die ersten und zweiten Wärmetransportelemente alternierend zueinander angeordnet sind. Der thermoelektrische Stack kann derart bestromt werden, dass sich an den ersten

Wärmetransportelementen eine Warmseite und den zweiten Wärmetransportelemente eine Kaltseite des thermoelektrischen Stack ausbildet. Ferner ist vorgesehen
- Verringern des Abstandes zwischen dem ersten Rohr und dem thermoelektrischen Stack zum Einführen von zumindest einem der ersten Wärmetransportelemente mit einem von dem thermoelektrischen Stack abgewandten Vorsprung in eine Durchbruchsöffnung in der Wandung des ersten Rohrs, derart dass der Vorsprung in den ersten Innenraum ragt und
- Verringern des Abstandes zwischen dem zweiten Rohr und dem thermoelektrischen Stack zum Einführen von zumindest einem der zweiten Wärmetransportelemente mit einem von dem thermoelektrischen Stack abgewandten Vorsprung in eine Durchbruchsöffnung in der Wandung des zweiten Rohrs, derart dass der Vorsprung in den zweiten Innenraum ragt
- Verbinden des thermoelektrischen Stacks mit dem ersten und / oder zweiten Rohr.

Ein weiteres Ausführungsbeispiel des Verfahrens zeichnet sich dadurch aus, dass das erste und/oder zweite Rohr als Kunststoff-Rohr aus einem thermisch schmelzbaren Kunststoff ausgebildet ist und folgende Schritte vorgesehen sind:
- Erhitzen zumindest des Vorsprungs eines Wärmetransportelements,
- Schaffung einer Durchbruchsöffnung mittels lokalen Schmelzens der Wandung des Kunststoff-Rohrs durch Pressen des erhitzten Vorsprungs des Wärmetransportelements an die Wandung
   und
- Einführen des Wärmetransportelements in die Durchbruchöffnung.

Nach den Einführungen des Wärmelements in die Durchbruchöffnung erstarrt das geschmolzene Kunststoffmaterial und umschließt im Bereich der Peripherie der Durchbruchöffnung den Vorsprung, womit eine Abdichtung zwischen der Innenseite und Aussenseite der Wandung des Rohrs hergestellt ist.

Weitere Vorteile, Merkmale und Einzelheiten der Erfindung ergeben sich aus der nachfolgenden Beschreibung, in der die Erfindung unter Bezug auf die Zeichnungen durch

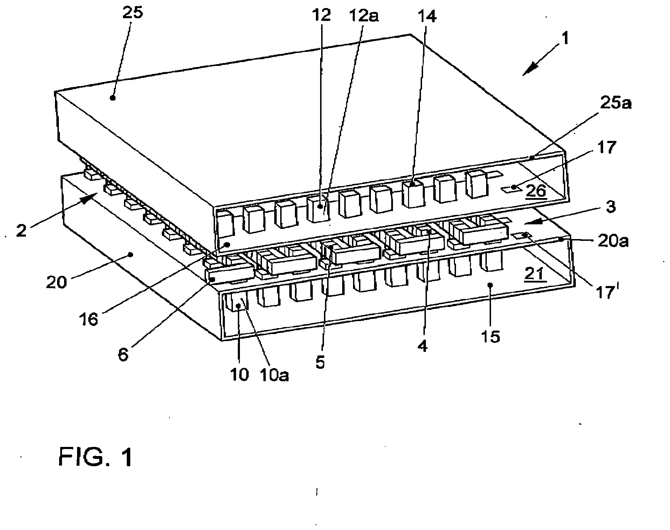

Ausführungsbeispiele im Einzelnen beschrieben ist. Gleiche, ähnliche und / oder funktionsgleiche Teile sind mit gleichen Bezugszeichen versehen. Es zeigt die einzige
Figur 1 eine schematische Darstellung eines erfindungsgemäßen Wärmeübertragers mit einer zwischen zwei Fluidpfaden angeordneten thermoelektrischen Schicht.

Figur 1 zeigt einen thermoelektrischen Wärmeübertrager zum Übertragen von nicht dargestellten Wärmeströmen einer thermoelektrischen Schicht 3 auf einen nicht dargestellten ersten Fluidstrom und einen ebenfalls nicht dargestellten zweiten Fluidstrom. Zum Führen des ersten Fluidstroms weist der Wärmeübertrager 1 einen ersten Fluidpfad auf. Zum Führen des zweiten Fluidstroms weist der Wärmeübertrager 1 einen zweiten Fluidpfad auf. Der erste Fluidpfad ist als erstes Flachrohr 20, der zweite Fluidpfad als zweites Flachrohr 25 ausgebildet.

Die thermoelektrische Schicht 3 ist von einer Vielzahl von nebeneinander angeordneten thermoelektrischen Stacks 2 gebildet. Aspekte eines derartigen thermoelektrischen Stacks 2 sind in der WO 2008/013946 A2 beschrieben, deren Offenbarungsgehalt in vollem Umfang durch Bezugnahme zum Offenbarungsgehalt der vorliegenden Patentanmeldung gemacht wird. Es wird insbesondere, aber nicht ausschließlich, auf die Figur 12 sowie die zugehörige Beschreibung, insbesondere Absätze [0147] - [0156] verwiesen, in denen Angaben über typische Dimensionierungen der Komponenten eines derartigen thermoelektrischen Stacks gemacht werden.

Ein thermoelektrischer Stack 2 umfasst eine Vielzahl von ersten Wärmetransportelementen 12 und eine Vielzahl von zweiten Wärmetransportelementen 10, typischerweise, jedoch nicht ausschließlich, als Brücken ausgebildet, die aus Kupfer oder einer Kupferlegierung bestehen.

In der Figur 1 sind die zweiten Wärmetransportelemente 10 jeweils sandwichartig zwischen zumindest zwei thermoelektrischen Pellets angeordnet, wobei eines der thermoelektrischen Pellets p-dotiert und das andere n-dotiert ist. In der Figur 1 ist dabei beispielhaft für ein im vierten Stack von links angeordnetes Wärmetransportelement ein Pellet 4 und für ein im dritten Stack von rechts angeordnetes Wärmetransportelement ein Pellet 5 mit Bezugszeichen versehen dargestellt.

Ferner ist, wie bereits weiter oben beschrieben ist, zumindest eines der ersten Wärmetransportelemente 12 sandwichartig zwischen zumindest zwei thermoelektrischen Pellets angeordnet.

Bei der thermoelektrischen Schicht 3 ist ein Wärmetransportelement 6 endseitig am von links gesehen ersten thermoelektrischen Stack angeordnet. Weitere Wärmetransportelemente (nicht mit Bezugszeichen versehen) sind in einer Abschlußreihe angeordnet und verbinden nebeneinander liegende thermoelektrische Stacks.

Die ersten und zweiten Wärmetransportelemente 10, 12 sind alternierend zueinander angeordnet, wobei zumindest einige der ersten Wärmetransportelemente 12 und zumindest einige der zweiten Wärmetransportelemente 10 in entgegen gesetzte Richtungen abstehen.

Der thermoelektrische Stack ist derart bestrombar, dass sich an den ersten Wärmetransportelemente 12 eine Warmseite und den zweiten Wärmetransportelementen 10 eine Kaltseite des thermoelektrischen Stack ausbildet. Aus der WO 2008/013946 A2 ist bekannt, dass bei einem derartigen Stack bei einer Dicke T_{B} = 2 mm eines zwischen den thermoelektrischen Pellets angeordneten Wärmetransportelementes die typische Länge eines Pellets in Stackrichtung um einen Faktor von 1 / 6.4 kleiner sein kann, als die entsprechende Länge bei einem konventionellen thermoelektrischen Element; vergleiche Gleichung (16) im Absatz [0149] der genannten WO bei Widerstandsverlusten, die vergleichbar einem konventionellen thermoelektrischen Modul sind.

Ein thermoelektrischer Stack 2 kann durch in der Figur 1 nicht dargestellte elektrische Kontaktierungen mit einer Gleichspannungsquelle verbunden werden, wobei die ersten Wärmetransportelemente 12 eine Warmseite und die zweiten Wärmetransportelemente 10 eine Kaltseite bilden. Dabei wirkt die Kaltseite als Wärmesenke und die Warmseite als Wärmequelle, wobei eine Umkehr der angelegten Spannung bewirkt, dass die Kaltseite als Wärmequelle und die Warmseite als Wärmesenke wirkt.

Bei dem erfindungsgemäßen thermoelektrischen Wärmeübertrager weisen die Wärmetransportelemente 10, 12 Vorsprünge auf, die mit Bezugszeichen 10a, 12a versehen sind und von denen zumindest einer eine Länge LV > 2,5 B_{B} aufweist, wobei B_{B} in der aus der WO 2008/013946 A2 bekannten Terminologie die aktive Breite des jeweiligen Wärmetransportelements bezeichnet.
Typischerweise hat eine Vielzahl von Vorsprüngen eine Länge LV > 2,5 B_{B} und kann damit den thermoelektrischen Stack direkt mit einem Wärmeträgermedium koppeln.

Bei dem erfindungsgemäßen thermoelektrischen Wärmeübertrager ragen die ersten Wärmetransportelemente 12 mit einem Vorsprung 12a durch Durchbruchsöffnungen der Wandung 20a des ersten Flachrohrs 20 und den ersten Innenraum 21 des ersten Flachrohrs 20; in der Figur 1 ist zur Vereinfachung nur ein Durchbruch 17 mit einem Bezugszeichen versehen. Analog ist in Figur 1 dargestellt, dass die zweiten Wärmetransportelemente 10 mit einem Vorsprung 10a durch eine Durchbruchsöffnung 17' in der Wandung 25a des zweiten Flachrohrs 25 in den Innenraum 26 ragen; in Figur 1 ist zur Vereinfachung der Darstellung lediglich eine Durchbruchsöffnung 17' mit Bezugszeichen versehen. Die ersten Wärmetransportelemente 12 bilden demnach eine Warmseite des thermoelektrischen Stacks 2 und ragen jeweils mit ihren Vorsprüngen 12a in den Innenraum 21 des ersten Flachrohrs 20. Entsprechend bilden die zweiten Wärmetransportelemente 10 demnach eine Warmseite des thermoelektrischen Stacks 2 und ragen mit ihren zugeordneten Vorsprüngen 10a in den Innenraum 26 des zweiten Flachrohrs 25.

Bei der durch eine Vielzahl von nebeneinander angeordneten thermoelektrischen Stacks 2 gebildeten thermoelektrischen Schicht 3 weisen sämtliche Stacks in gleicher Richtung orientierte Warm- bzw. Kaltseiten auf.

Bei Verwendung eines in Figur 1 dargestellten thermoelektrischen Wärmeübertragers in Heiz-und Klimatisierungssystemen kann vorzugsweise ein zu kühlendes Fluid durch das erste Flachrohr 20 geleitet und ein zu heizendes Fluid durch das zweite Flachrohr 25 geleitet werden. Dabei kann durch Anlegen einer elektrischen Gleichspannung thermische Energie vom einen Fluid über den thermoelektrischen Stack in das andere Fluid gepumpt werden.

In einer weiteren Ausführungsform der Erfindung ist eine Vielzahl von thermoelektrischen Schichten 3 vorgesehen, wie sie beispielsweise in Figur 1 dargestellt sind. Je zwischen zwei thermoelektrischen Schichten ist dabei zumindest ein Fluidpfad sandwichartig angeordnet, wobei diese Schichten im Folgenden als korrespondierende Schichten bezeichnet werden. Jede der thermoelektrischen Schichten weist eine Warmseite und eine Kaltseite auf. Ein zwischen jeweils zwei thermoelektrischen Schichten angeordneter Fluidpfad steht auf jeder seiner beiden Seiten in Kontakt mit den Warmseiten oder den Kaltseiten der thermoelektrischen Schichten. Einem gegebenen Fluidpfad sind dementsprechend jeweils thermoelektrische Schichten benachbart, die so bestromt oder bestrombar sind, dass gleichartige Seiten an den Fluidpfad thermisch ankoppeln. Im Betrieb eines derartigen Wärmeübertragers ragen daher die Vorsprünge von Wärmetransportelementen, die eine Warmseite bilden, stets in ein zu heizendes Fluid und die Vorsprünge von Wärmetransportelementen, die eine Kaltseite bilden, stets in ein zu kühlendes Fluid. Korrespondierenden thermoelektrischen Schichten ist jeweils ein gemeinsames Flachrohr zugeordnet.

Während in einer Ausführungsform der Erfindung die Vorsprünge korrespondierender benachbarter thermoelektrischer Schichten mit entgegen gesetzter Orientierung in ein gemeinsames Flachrohr zum Führen eines zu heizenden bzw. zu kühlenden Fluids angeordnet sind, ist in einer weiteren Ausführungsform der Erfindung vorgesehen, dass die Vorsprünge von korrespondierenden thermoelektrischen Schichten entsprechend jeweils in ein separates Flachrohr hineinragen.

Zur Vermeidung von elektrischen Kurzschlüssen zwischen den ersten Wärmetransportelementen 10 untereinander und den zweiten Wärmetransportelementen 12 untereinander sind Isolationsmittel vorgesehen. Beispielsweise können die Vorsprünge 10a, 12a mit einer elektrisch nicht leitenden Beschichtung 14 versehen sein. Bevorzugt ist diese elektrisch nicht leitende Beschichtung 14 dabei thermisch leitend. Bevorzugt sind als Material für eine derartige Beschichtung Keramiken wie beispielsweise Al₂O₃, AIN oder Lacke. Zweckmäßig ist es, wenn das erste und / oder zweite Flachrohr aus einem elektrisch nicht leitenden Material hergestellt ist, da dann keine zusätzliche Isolation der Wärmetransportelemente gegenüber dem jeweiligen Flachrohr, in das sie hineinragen, erforderlich ist.

Zweckmäßig ist es, als nicht-leitendes Material der Flachrohre 20, 25 ein Kunststoffmaterial einzusetzen. Dann können Durchbruchöffnungen, beispielsweise Durchbruchöffnungen 17, 17', durch Schmelzen des Materials der Wandung der Flachrohre 20, 25 hergestellt werden.

Günstigerweise kann das Schmelzen des Materials durch Anwendung von erhitzten Wärmetransportelementen auf die Wandung eines betreffenden Flachrohrs erfolgen. Das Erhitzen von Wärmetransportelementen kann dabei beispielsweise induktiv erfolgen.

Bei der Herstellung eines thermoelektrischen Wärmeübertragers, wie in Figur 1 dargestellt, kann daher wie folgt vorgegangen werden: Es wird ein erstes Flachrohr 20 bereitgestellt und positioniert, welches als erster Fluidpfad vorgesehen ist. Ferner wird ein zweites Flachrohr 25 bereitgestellt und positioniert, welches als zweiter Fluidpfad vorgesehen ist. Außerdem wird ein thermoelektrischer Stack 2 bereitgestellt und positioniert, der in einer sandwichartigen Anordnung zwischen dem ersten Flachrohr 20 und dem zweiten Flachrohr 25 im hergestellten thermoelektrischen Wärmeübertrager vorgesehen ist. Die Positionierung der Komponenten ermöglicht anschliessend die Herstellung einer mechanischen Verbindung zwischen ihnen.

Mit einer geeigneten Vorrichtung wird der Abstand zwischen dem ersten Flachrohr 20 und dem thermoelektrischen Stack 2 vermindert, um die Vorsprünge 10a der ersten Wärmetransportelemente 10 in die Durchbruchsöffnungen der Wandung des ersten Flachrohrs 20 einzuführen, bis die gewünschte Positionierung der Vorsprünge 21 im Innenraum des ersten Flachrohrs 20 erreicht ist. Analog wird beim Einführen der Vorsprünge der zweiten Wärmetransportelemente in die Durchbruchsöffnungen in der Wandung des zweiten Flachrohrs vorgegangen. Falls die Flachrohre aus einem thermisch schmelzbaren Kunststoff ausgebildet sind, kann durch Erhitzen der Vorsprünge der Wärmetransportelemente die Schaffung der Durchbruchsöffnungen einfach durch Pressen von erhitzten Vorsprüngen an die jeweiligen Wandungen erfolgen.

Der erfindungsgemäße thermoelektrische Wärmeübertrager ermöglicht eine vollständige Ersparnis eines üblicherweise bei konventionellen thermoelektrischen Wärmeübertragern üblichen Materials zwischen dem thermoelektrischen Stack und dem zur Wärmeübertragung eingesetzten Fluid eines Fluid- oder Kältemittelkreislaufs, da die Wärmetransportvorrichtungen mit ihren Vorsprüngen unmittelbar in das wärmeübertragende Medium hinein ragen. Ansonsten auftretende Verluste durch Wärmeübergänge werden minimiert und die Effizienz des thermoelektrischen Wärmeübertragers erhöht.

## Patentansprüche

1. Thermoelektrischer Wärmeübertrager zum Übertragen von Wärmeströmen von thermoelektrischen Pellets auf einen ersten Fluidstrom und einen zweiten Fluidstrom mit zumindest einem ersten Fluidpfad zum Führen des ersten Fluidstroms und zumindest einem zweiten Fluidpfad zum Führen des zweiten Fluidstroms und zumindest einem sandwichartig zwischen dem ersten Fluidpfad und dem zweiten Fluidpfad angeordneten oder anordenbaren thermoelektrischen Stack (2), wobei
- der thermoelektrische Stack (2) eine Vielzahl von ersten Wärmetransportelementen (12) und eine Vielzahl von zweiten Wärmetransportelementen (10) aufweist,
- zumindest eines der ersten Wärmetransportelemente (12) und zumindest eines der zweiten Wärmetransportelemente (10) sandwichartig zwischen zumindest zwei thermoelektrischen Pellets angeordnet ist,
- abwechselnd p-dotierte und n-dotierte Pellets (4, 5) angeordnet sind,
- die ersten und zweiten Wärmetransportelemente (10, 12) alternierend zueinander angeordnet sind und
- der thermoelektrische Stack (2) derart bestrombar ist, dass sich an den ersten Wärmetransportelementen (12) eine Warmseite und den zweiten Wärmetransportelementen (10) eine Kaltseite des thermoelektrischen Stack (2) ausbildet,
der erste Fluidpfad als erstes Rohr (20) ausgebildet ist, wobei zumindest eines der ersten Wärmetransportelemente (12) mit einem von dem thermoelektrischen Stack (2) abgewandten Vorsprung (12a) durch eine Durchbruchsöffnung (17) in der Wandung (20a) des ersten Rohrs (20) in einen das erste Fluid aufnehmenden ersten Innenraum (21) ragt und / oder wobei der zweite Fluidpfad als zweites Rohr (25) ausgebildet ist, wobei eines der zweiten Wärmetransportelemente (10) mit einem von dem thermoelektrischen Stack (2) abgewandten Vorsprung (10a) durch eine Durchbruchsöffnung (17) in der Wandung (25a) des zweiten Rohrs (25) in einen das zweite Fluid aufnehmenden zweiten Innenraum (26) ragt, **dadurch gekennzeichnet, dass** zumindest einer der durch die Wandung des ersten und/oder zweiten Rohrs (20, 25) in den Innenraum ragenden Vorsprünge (10a, 12a) mit einer elektrisch nichtleitenden, thermisch leitenden Beschichtung (14, 16) versehen ist.

2. Thermoelektrischer Wärmeübertrager nach Anspruch 1, **dadurch gekennzeichnet, dass** eine von einer Vielzahl von nebeneinander angeordneten oder anordenbaren thermoelektrischen Stacks (2) mit in gleicher Richtung orientierten Warm- und Kaltseiten gebildete thermoelektrische Schicht (3) vorgesehen ist.

3. Thermoelektrischer Wärmeübertrager nach Anspruch 1 oder 2, **dadurch gekennzeichnet, dass** eine Vielzahl von thermoelektrischen Schichten (3) mit zumindest einem sandwichartig zwischen jeweils zwei der thermoelektrischen Schichten angeordneten oder anordenbaren Fluidpfad vorgesehen sind, wobei die thermoelektrischen Schichten (3) eine Warmseite und eine Kaltseite aufweisen und derartig relativ zu einem dazwischen liegenden Fluidpfad orientiert sind, dass dem Fluidpfad jeweils thermoelektrische Schichten (3) entweder mit ihren Warmseiten oder mit ihren Kaltseiten benachbart sind.

4. Thermoelektrischer Wärmeübertrager nach einem der vorhergehenden Ansprüche, **dadurch gekennzeichnet, dass** zumindest eines der Wärmetransportelemente (10, 12) einen Vorsprung (10a, 12a) mit der Länge LV > 2 BB aufweist, wobei BB die aktive Breite des Wärmetransportelements (10, 12) ist.

5. Thermoelektrischer Wärmeübertrager nach einem der vorhergehenden Ansprüche, **dadurch gekennzeichnet, dass** das erste und / oder zweite Rohr (20, 25) aus einem elektrisch nicht leitenden Material hergestellt ist.

6. Thermoelektrischer Wärmeübertrager nach einem der vorhergehenden Ansprüche, **dadurch gekennzeichnet, dass** das erste und / oder zweite Rohr (20) aus einem vorzugsweise thermisch schmelzbaren Kunststoffmaterial hergestellt ist.

7. Thermoelektrischer Wärmeübertrager nach einem der vorhergehenden Ansprüche, **dadurch gekennzeichnet, dass** zumindest eine der Durchbruchöffnungen (17') durch eine Erhitzung von zumindest einem der Wärmetransportelemente (10, 12) und Schmelzen eines Materials des ersten oder zweiten Rohrs (20, 25) mittels des erhitzten Wärmetransportelements (10, 12) herstellbar oder hergestellt ist.

8. Verfahren zur Herstellung eines thermoelektrischen Wärmeübertragers zum Übertragen von Wärmeströmen von den thermoelektrischen Pellets auf einen ersten und einen zweiten Fluidstrom mit zumindest einem ersten Fluidpfad zum Führen des ersten Fluidstroms und zumindest einem zweiten Fluidpfad zum Führen des zweiten Fluidstroms und zumindest einem zwischen dem ersten Fluidpfad und dem zweiten Fluidpfad angeordneten oder anordenbaren thermoelektrischen Stack (2), wobei
- der thermoelektrische Stack (2) eine Vielzahl von ersten Wärmetransportelementen (12) und eine Vielzahl von zweiten Wärmetransportelementen (10) aufweist,
- zumindest eines der ersten Wärmetransportelemente (12) und zumindest eines der zweiten Wärmetransportelemente (10) sandwichartig zwischen zumindest zwei thermoelektrischen Pellets angeordnet wird,
- abwechselnd p-dotierte und n-dotierte Pellets (4, 5) angeordnet sind,
- die ersten und zweiten Wärmetransportelemente (10, 12) alternierend zueinander angeordnet werden und
- der thermoelektrische Stack (2) derart bestrombar ist, dass sich an den ersten Wärmetransportelementen (12) eine Warmseite und den zweiten Wärmetransportelementen (10) eine Kaltseite des thermoelektrischen Stack (2) ausbildet, **gekennzeichnet durch**
- Bereitstellen und Positionieren eines ersten Rohrs (20), welches als erster Fluidpfad vorgesehen ist,
- Bereitstellen und Positionieren eines zweiten Rohrs (25), welches als zweiter Fluidpfad vorgesehen ist,
- Bereitstellen und Positionieren des thermoelektrischen Stacks (2),
- Verringern des Abstandes zwischen dem ersten Rohr (20) und dem thermoelektrischen Stack (2) zum Einführen von zumindest einem der ersten Wärmetransportelemente (12) mit einem von dem thermoelektrischen Stack (2) abgewandten Vorsprung in eine Durchbruchsöffnung (17) in der Wandung (20a) des ersten Rohrs (20), derart dass der Vorsprung in den ersten Innenraum (21) ragt, und
- Verringern des Abstandes zwischen dem zweiten Rohr (25) und dem thermoelektrischen Stack (2) zum Einführen von zumindest einem der zweiten Wärmetransportelemente (10) mit einem von dem thermoelektrischen Stack (2) abgewandten Vorsprung in eine Durchbruchsöffnung (17') in der Wandung (25a) des zweiten Rohrs (25), derart dass der Vorsprung in den zweiten Innenraum (26) ragt,
- Verbinden des thermoelektrischen Stacks (2) mit dem ersten und zweiten Rohr (20, 25).

9. Verfahren nach Anspruch 8, **dadurch gekennzeichnet, dass** das erste und/oder zweite Rohr (20, 25) als Kunststoff-Rohr aus einem thermisch schmelzbaren Kunststoff ausgebildet ist und folgende Schritte vorgesehen sind:
- Erhitzen zumindest des Vorsprunges eines Wärmetransportelements (10, 12),
- Schaffung einer Durchbruchsöffnung (17, 17') mittels lokalen Schmelzens der Wandung (20a, 25a) des Kunststoff-Rohrs (20, 25) durch Pressen des erhitzten Vorsprunges des Wärmetransportelements (10, 12) an die Wandung (20a, 25a) und
- Einführen des Wärmetransportelements (10, 12) in die Durchbruchöffnung (17, 17').

## Claims

1. Thermoelectric heat exchanger for transferring heat flows from thermoelectric pellets to a first fluid flow and a second fluid flow with at least one first fluid path for conducting the first fluid flow and at least one second fluid path for conducting the second fluid flow and at least one thermoelectric stack (2), which is arranged or can be arranged between the first fluid path and the second fluid path in a sandwich-like manner, wherein
- the thermoelectric stack (2) has a multiplicity of first heat transporting elements (12) and a multiplicity of second heat transporting elements (10),
- at least one of the first heat transporting elements (12) and at least one of the second heat transporting elements (10) is arranged between at least two thermoelectric pellets in a sandwich-like manner,
- p-doped and n-doped pellets (4, 5) are arranged alternately,
- the first and second heat transporting elements (10, 12) are arranged alternating in relation to one another and
- the thermoelectric stack (2) can be supplied with current in such a way that a warm side of the thermoelectric stack (2) forms at the first heat transporting elements (12) and a cold side of the thermoelectric stack (2) forms at the second heat transporting elements (10),
the first fluid path is formed as a first tube (20), wherein at least one of the first heat transporting elements (12) protrudes with a projection (12a) that is facing away from the thermoelectric stack (2) through an aperture (17) in the wall (20a) of the first tube (20) into a first internal space (21) receiving the first fluid and/or wherein the second fluid path is formed as a second tube (25), wherein one of the second heat transporting elements (10) protrudes with a projection (10a) that is facing away from the thermoelectric stack (2) through an aperture (17) in the wall (25a) of the second tube (25) into a second internal space (26) receiving the second fluid, **characterized in that** at least one of the projections (10a, 12a) protruding through the wall of the first and/or second tube (20, 25) into the internal space is provided with an electrically nonconducting, thermally conducting coating (14, 16) .

2. Thermoelectric heat exchanger according to Claim 1, **characterized in that** a thermoelectric layer (3) formed by a multiplicity of thermoelectric stacks (2) which are arranged or can be arranged next to one another and have warm and cold sides oriented in the same direction is provided.

3. Thermoelectric heat exchanger according to Claim 1 or 2, **characterized in that** a multiplicity of thermoelectric layers (3) with at least one fluid path which is arranged or can be arranged between two of the thermoelectric layers respectively in a sandwich-like manner are provided, wherein the thermoelectric layers (3) have a warm side and a cold side and are oriented in relation to a fluid path lying in between in such a way that thermoelectric layers (3) are respectively alongside the fluid path either with their warm sides or with their cold sides.

4. Thermoelectric heat exchanger according to one of the preceding claims, **characterized in that** at least one of the heat transporting elements (10, 12) has a projection (10a, 12a) with the length LV > 2 BB, where BB is the active width of the heat transporting element (10, 12).

5. Thermoelectric heat exchanger according to one of the preceding claims, **characterized in that** the first and/or second tube (20, 25) is/are produced from an electrically nonconducting material.

6. Thermoelectric heat exchanger according to one of the preceding claims, **characterized in that** the first and/or second tube (20) is/are produced from a preferably thermally meltable plastics material.

7. Thermoelectric heat exchanger according to one of the preceding claims, **characterized in that** at least one of the apertures (17') can be produced or is produced by heating at least one of the heat transporting elements (10, 12) and melting a material of the first or second tube (20, 25) by means of the heated heat transporting element (10, 12).

8. Method for producing a thermoelectric heat exchanger for transferring heat flows from the thermoelectric pellets to a first and a second fluid flow with at least one first fluid path for conducting the first fluid flow and at least one second fluid path for conducting the second fluid flow and at least one thermoelectric stack (2), which is arranged or can be arranged between the first fluid path and the second fluid path, wherein
- the thermoelectric stack (2) has a multiplicity of first heat transporting elements (12) and a multiplicity of second heat transporting elements (10),
- at least one of the first heat transporting elements (12) and at least one of the second heat transporting elements (10) is arranged between at least two thermoelectric pellets in a sandwich-like manner,
- p-doped and n-doped pellets (4, 5) are arranged alternately,
- the first and second heat transporting elements (10, 12) are arranged alternating in relation to one another and
- the thermoelectric stack (2) can be supplied with current in such a way that a warm side of the thermoelectric stack (2) forms at the first heat transporting elements (12) and a cold side of the thermoelectric stack (2) forms at the second heat transporting elements (10), **characterized by**
- providing and positioning a first tube (20), which is intended as the first fluid path,
- providing and positioning a second tube (25) which is intended as the second fluid path,
- providing and positioning the thermoelectric stack (2),
- reducing the distance between the first tube (20) and the thermoelectric stack (2) for inserting at least one of the first heat transporting elements (12) with a projection that is facing away from the thermoelectric stack (2) into an aperture (17) in the wall (20a) of the first tube (20) in such a way that the projection protrudes into the first internal space (21), and
- reducing the distance between the second tube (25) and the thermoelectric stack (2) for inserting at least one of the second heat transporting elements (10) with a projection that is facing away from the thermoelectric stack (2) into an aperture (17') in the wall (25a) of the second tube (25) in such a way that the projection protrudes into the second internal space (26),
- connecting the thermoelectric stack (2) to the first and second tubes (20, 25).

9. Method according to Claim 8, **characterized in that** the first and/or second tube(s) (20, 25) is/are formed as a plastic tube of a thermally meltable plastic and the following steps are provided:
- heating at least the projection of a heat transporting element (10, 12),
- creating an aperture (17, 17') by means of locally melting the wall (20a, 25a) of the plastic tube (20, 25) by pressing the heated projection of the heat transporting element (10, 12) against the wall (20a, 25a) and
- inserting the heat transporting element (10, 12) into the aperture (17, 17').

## Revendications

1. Échangeur de chaleur thermoélectrique pour le transfert de flux de chaleur de pastilles thermoélectriques à un premier courant de fluide et un deuxième courant de fluide avec au moins un premier chemin de fluide pour guider le premier courant de fluide et au moins un deuxième chemin de fluide pour guider le deuxième courant de fluide, et au moins un empilement thermoélectrique (2) disposé ou pouvant être disposé en sandwich entre le premier chemin de fluide et le deuxième chemin de fluide,
- l'empilement thermoélectrique (2) présentant une pluralité de premiers éléments de transport de chaleur (12) et une pluralité de deuxièmes éléments de transport de chaleur (10),
- au moins l'un des premiers éléments de transport de chaleur (12) et au moins l'un des deuxièmes éléments de transport de chaleur (10) étant disposés en sandwich entre au moins deux pastilles thermoélectriques,
- des pastilles dopées p et dopées n (4, 5) étant disposées en alternance,
- les premiers et les deuxièmes éléments de transport de chaleur (10, 12) étant disposés en alternance les uns avec les autres, et
- l'empilement thermoélectrique (2) pouvant être alimenté en courant de telle sorte qu'il se forme au niveau des premiers éléments de transport de chaleur (12) un côté chaud et au niveau des deuxièmes éléments de transport de chaleur (10) un côté froid de l'empilement thermoélectrique (2),
le premier chemin de fluide étant réalisé sous forme de premier tube (20), au moins l'un des premiers éléments de transport de chaleur (12) faisant saillie avec une saillie (12a) opposée à l'empilement thermoélectrique (2) à travers une ouverture de passage (17) dans la paroi (20a) du premier tube (20) dans un premier espace interne (21) recevant le premier fluide et/ou le deuxième chemin de fluide étant réalisé sous forme de deuxième tube (25), l'un des deuxièmes éléments de transport de chaleur (10) faisant saillie avec une saillie (10a) opposée à l'empilement thermoélectrique (2) à travers une ouverture de passage (17) dans la paroi (25a) du deuxième tube (25) dans un deuxième espace interne (26) recevant le deuxième fluide, **caractérisé en ce qu'**au moins l'une des saillies (10a, 12a) pénétrant dans l'espace interne à travers la paroi du premier et/ou du deuxième tube (20, 25) est pourvue d'un revêtement électriquement non conducteur, thermiquement conducteur (14, 16).

2. Échangeur de chaleur thermoélectrique selon la revendication 1, **caractérisé en ce qu'**il est prévu une couche thermoélectrique (3) formée par une pluralité d'empilements thermoélectriques (2) disposés ou pouvant être disposés les uns à côté des autres avec des côtés chauds et des côtés froids orientés dans le même sens.

3. Échangeur de chaleur thermoélectrique selon la revendication 1 ou 2, **caractérisé en ce qu'**il est prévu une pluralité de couches thermoélectriques (3) avec au moins un chemin de fluide disposé ou pouvant être disposé en sandwich entre deux des couches thermoélectriques respectives, les couches thermoélectriques (3) présentant un côté chaud et un côté froid et étant orientées par rapport à un chemin de fluide situé entre elles de telle sorte que des couches thermoélectriques respectives (3) soient à chaque fois adjacentes au chemin de fluide par leurs côtés chauds ou par leurs côtés froids.

4. Échangeur de chaleur thermoélectrique selon l'une quelconque des revendications précédentes, **caractérisé en ce qu'**au moins l'un des éléments de transport de chaleur (10, 12) présente une saillie (10a, 12a) de longueur LV > 2 BB, BB étant la largeur active de l'élément de transport de chaleur (10, 12).

5. Échangeur de chaleur thermoélectrique selon l'une quelconque des revendications précédentes, **caractérisé en ce que** le premier et/ou le deuxième tube (20, 25) sont fabriqués à partir d'un matériau non conducteur électrique.

6. Échangeur de chaleur thermoélectrique selon l'une quelconque des revendications précédentes, **caractérisé en ce que** le premier et/ou le deuxième tube (20) se composent d'un matériau en plastique de préférence thermofusible.

7. Échangeur de chaleur thermoélectrique selon l'une quelconque des revendications précédentes, **caractérisé en ce qu'**au moins l'une des ouvertures de passage (17') peut être fabriquée ou est fabriquée par chauffage d'au moins l'un des éléments de transport de chaleur (10, 12) et fusion d'un matériau du premier et/ou du deuxième tube (20, 25) au moyen de l'élément de transport de chaleur chauffé (10, 12).

8. Procédé de fabrication d'un échangeur de chaleur thermoélectrique pour le transfert de flux de chaleur des pastilles thermoélectriques à un premier courant de fluide et un deuxième courant de fluide avec au moins un premier chemin de fluide pour guider le premier courant de fluide et au moins un deuxième chemin de fluide pour guider le deuxième courant de fluide, et au moins un empilement thermoélectrique (2) disposé ou pouvant être disposé entre le premier chemin de fluide et le deuxième chemin de fluide,
- l'empilement thermoélectrique (2) présentant une pluralité de premiers éléments de transport de chaleur (12) et une pluralité de deuxièmes éléments de transport de chaleur (10),
- au moins l'un des premiers éléments de transport de chaleur (12) et au moins l'un des deuxièmes éléments de transport de chaleur (10) étant disposés en sandwich entre au moins deux pastilles thermoélectriques,
- des pastilles dopées p et dopées n (4, 5) étant disposées en alternance,
- les premiers et les deuxièmes éléments de transport de chaleur (10, 12) étant disposés en alternance les uns avec les autres, et
- l'empilement thermoélectrique (2) pouvant être alimenté en courant de telle sorte qu'il se forme au niveau des premiers éléments de transport de chaleur (12) un côté chaud et au niveau des deuxièmes éléments de transport de chaleur (10) un côté froid de l'empilement thermoélectrique (2), **caractérisé par**
- la fourniture et le positionnement d'un premier tube (20) qui est prévu en tant que premier chemin de fluide,
- la fourniture et le positionnement d'un deuxième tube (25) qui est prévu en tant que deuxième chemin de fluide,
- la fourniture et le positionnement de l'empilement thermoélectrique (2),
- la réduction de la distance entre le premier tube (20) et l'empilement thermoélectrique (2) pour introduire au moins l'un des premiers éléments de transport de chaleur (12) avec une saillie opposée à l'empilement thermoélectrique (2) dans une ouverture de passage (17) dans la paroi (20a) du premier tube (20), de telle sorte que la saillie pénètre dans le premier espace interne (21), et
- la réduction de la distance entre le deuxième tube (25) et l'empilement thermoélectrique (2) pour introduire au moins l'un des deuxièmes éléments de transport de chaleur (10) avec une saillie opposée à l'empilement thermoélectrique (2) dans une ouverture de passage (17') dans la paroi (25a) du deuxième tube (25) de telle sorte que la saillie pénètre dans le deuxième espace interne (26),
- la connexion de l'empilement thermoélectrique (2) au premier et au deuxième tube (20, 25).

9. Procédé selon la revendication 8, **caractérisé en ce que** le premier et/ou le deuxième tube (20, 25) sont réalisés sous forme de tube en plastique thermofusible et les étapes suivantes sont prévues :
- chauffage d'au moins la saillie d'un élément de transport de chaleur (10, 12),
- création d'une ouverture de passage (17, 17') au moyen d'une fusion locale de la paroi (20a, 25a) du tube en plastique (20, 25) par pressage de la saillie chauffée de l'élément de transport de chaleur (10, 12) contre la paroi (20a, 25a) et
- introduction de l'élément de transport de chaleur (10, 12) dans l'ouverture de passage (17, 17').
